(19) Europäisches Patentamt
European Patent Office
Office européen des brevets

(11) Veröffentlichungsnummer : **0 458 740 A1**

(12) # EUROPÄISCHE PATENTANMELDUNG

(21) Anmeldenummer : **91810320.1**

(51) Int. Cl.$^5$ : **C09J 161/20,** C09J 163/00

(22) Anmeldetag : **26.04.91**

(30) Priorität : **23.05.90 DE 4016548**

(43) Veröffentlichungstag der Anmeldung :
**27.11.91 Patentblatt 91/48**

(84) Benannte Vertragsstaaten :
**AT BE CH DE ES FR GB IT LI NL SE**

(71) Anmelder : **Gurit-Essex AG**
**CH-8807 Freienbach (CH)**

(72) Erfinder : **Schreiber, Herbert**
**Seeblick 3**
**CH-8832 Wollerau (CH)**
Erfinder : **Saur, Wolfgang, Dr.**
**Tafletenstrasse 5**
**CH-8863 Buttikon (CH)**

(74) Vertreter : **Rottmann, Maximilian R. et al**
**c/o Rottmann, Zimmermann + Partner AG**
**Glattalstrasse 37**
**CH-8052 Zürich (CH)**

(54) **Verfahren zum Verkleben von Polyimidfolien und nach dem Verfahren hergestellte Leiterplatten.**

(57) Der Klebstoff, welcher einen Gehalt an einem härtbaren Oxazenharz, welches mindestens eine 1-Oxa-3-aza-tetralin-Gruppe im Molekül enthält, gegebenenfalls in Kombination mit mindestens einer härtbaren Epoxyverbindung, aufweist, dient zum Verkleben von Polyimidfolien mit gleichartigen Folien oder anderen Substraten, insbesondere Metallfolien. Solche Verklebungen eignen sich für die Herstellung von Leiterplatten, insbesondere flexiblen Leiterplatten, mit hoher Wärmebeständigkeit und Schälfestigkeit.

EP 0 458 740 A1

Jouve, 18, rue Saint-Denis, 75001 PARIS

Die Erfindung betrifft ein Verfahren zum Verkleben von Polyimidfolien, wie sie in den Ansprüchen 1 bis 20 umschrieben ist, sowie nach diesem Verfahren hergestellte Leiterplatten, wie sie im Anspruch 21 umschrieben sind.

Polyimide sind bekanntlich Kunststoffe, welche in der Hauptkette die Gruppierung

-CO-NR-CO-

als lineare Einheit oder die Gruppierung

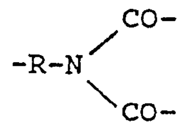

als heterocyclische Einheit aufweisen. Sie sind die Kondensationsprodukte aus polyfunktionellen Carbonsäureanhydriden und primären Diaminen.

Typische Beispiele solcher Polyimide sind die unter dem Handelsnamen "Kapton" (eingetragenes Warenzeichen der DuPont) im Handel befindlichen Polypyromellitimide, welche durch Umsetzung von Pyromellitdianhydrid mit aromatischen Diaminen, wie m-Phenylendiamin oder Bis(4-Aminophenyl)ether, erhältlich sind.

Sie weisen hervorragende thermische Eigenschaften auf. Daher stellen daraus hergestellte Folien ideale Materialien für die Herstellung von flexiblen Leiterplatten dar.

So weist z.B. eine handelsübliche Polyimidfolie aus "Kapton H" folgende typischen Eigenschaften auf:

| | |
|---|---|
| Dichte | 1,4 g/cm$^3$ |
| Dicke | 0,0075...0,125 mm |
| Elektr. Durchschlagsspannung | 140...270 kV/mm |
| Zugfestigkeit, längs | 170 N/mm$^2$ |
| Zugfestigkeit, quer | 170 N/mm$^2$ |
| Grenztemperatur | >180°C |

Nachteilig war aber, dass die bisher für eine Verklebung mit Metallen, insbesondere Kupfer, zur Verfügung stehenden Klebstoffe zu wenig wärmebeständig waren und eine zu geringe Schälfestigkeit der Verklebung ergaben.

Aufgabe der vorliegenden Erfindung ist daher die Schaffung von Klebstoffen für die Verklebung von Polyimidfolien, welche eine verbesserte Wärmebeständigkeit und eine verbesserte Schälfestigkeit der Verklebung aufweisen.

Diese Aufgabe wird erfindungsgemäss gelöst durch die Verwendung von thermisch härtbaren Verbindungen, welche mindestens eine 1-Oxa-3-aza-tetralin-Gruppe enthalten, gegebenenfalls in Kombination mit härtbaren Epoxyverbindungen, als Klebstoffe. Diese Verbindungen sowie deren Vorpolymere werden im folgenden zusammen als "Oxazenharze" bezeichnet.

Die erfindungsgemässen Klebstoffe eignen sich für die Verklebung der Polyimidfolien sowohl mit gleichartigen Folien als auch mit anderen Substraten, insbesondere Metallen in Form von Blechen oder Folien, vorzugsweise Kupfer-, Aluminium-, Nickel- oder Widerstandsfolien.

Oxazenharze sind bekanntlich 1-Oxa-3-aza-tetralin-Gruppen enthaltende Verbindungen und deren Vorpolymere. Sie sind z.B aus den Veröffentlichungen CH-A5-574 978, 579 113 und 606 169 sowie EP-A1-0 356 379 bekannt.

Für die vorliegende Erfindung geeignete Oxazenharze und deren Herstellung sind in der erwähnten Veröffentlichung EP-A1-0 356 379 beschrieben.

Als Epoxyharze eignen sich insbesondere mono- oder mehrfunktionelle, thermisch, katalytisch oder durch Härtersubstanzen härtbare Epoxyverbindungen. Geeignete Epoxyverbindungen sind z.B. beschrieben in:

- Sidney H. Goodman, Handbook of Thermoset Plastics, Noyes Publications, Park Ridge, NJ;
- W. G. Potter, Epoxide Resins, Ilife Books, London;
- Henry Lee und Kris Neville, Handbook of Epoxy Resins, McGraw-Hill Book Company, New York/San Francisco/Toronto/London.

Besonders geeignet sind cycloaliphatische Epoxyverbindungen, wie sie ebenfalls in der erwähnten Veröffentlichung EP-A1-0 356 379 beschrieben sind.

Mittels der vorliegenden Erfindung lassen sich für Verklebungen von Polyimidfolien mit Kupferfolien Schälfestigkeiten bis über 1,7 N/mm erzielen, wobei das Versagen jeweils durch Reissen der Polyimidfolie bedingt ist. Die Reissfestigkeit der mit einer Kupferfolie verklebten Polyimidfolie beträgt nach dem Abätzen des Kupfers noch bis zu über 85 % des Ausgangswertes. Die Glasübergangstemperatur $T_g$ (auch Glastemperatur genannt) der Verklebung liegt bei etwa 250°C.

Ausführungsbeispiele

1. Ausgangsmaterialien

In den folgenden Beispielen werden folgende Ausgangsmaterialien verwendet:

1.1 Kupferfolien

(Cu/1) Kupferfolie 1
Typ "Beige", geätzt - Hersteller: Gould
Dicke: 0,035 mm
Flächengewicht: 288 $g/m^2$

(Cu/2) Kupferfolie 2
Typ "CTF R8", geätzt - Hersteller: Fukuda
Dicke: 0,035 mm
Flächengewicht: 288 $g/m^2$

1.2 Polyimidfolien

(PI/1) Polyimidfolie 1
Typ "100 HN"
Dicke: 0,02 mm

(PI/2) Polyimidfolie 2
Typ "Kapton"
Dicke: 0,02 mm

2. Klebstoff

Als Klebstoff wurde eine Mischung des Oxazenharzes und der Epoxyverbindung in den nachstehend unter 2.3 angegebenen Gewichtsverhältnissen verwendet

2.1 Oxazenharze

(Ox/1) oxazenhaz 1
Umsetzungsprodukt von 4,4'-Diamino-diphenylmethan mit Phenol und Formaldehyd im Molverhältnis 1:2:4 der Strukturformel:

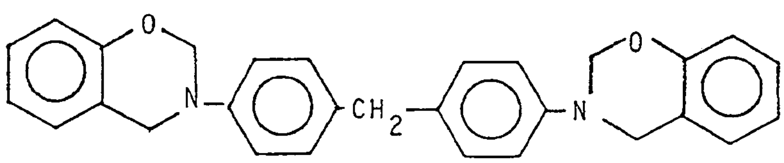

(Ox/2) oxazenharz 2
Umsetzungsprodukt von 1 Mol (2 Äqu) des durch Umsetzung von 2 Mol Phenol und 1 Mol Formaldehyd erhaltenen Novolaks mit 2 Mol Anilin und 4 Mol Formaldehyd zu einem Produkt der mittleren Zusammensetzung:

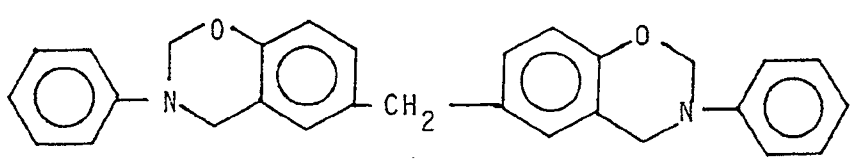

2.2 Epoxyverbindungen

(Ep/1) Epoxyverbindung 1
3,4-Epoxycyclohexylmethyl-3,4-epoxy-cyclohexan-carboxylat (Handelsbezeichnung "Araldit CY 179")

(Ep/2) Epoxyverbindung 2
2-(3,4-Epoxy)cyclohexyl–5,5-spiro(3,4-epoxy)cyclohexan-m-dioxan (Handelsbezeichnung "Araldit CY 175")

2.3 Kleberzusammensetzung

| Kleber | Ox/1 | Ox/2 | Ep/1 | Ep/2 | (Gewichtsteile) |
|---|---|---|---|---|---|
| Kl/1 | 67 | | 33 | | |
| Kl/2 | 60 | | | 40 | |
| Kl/3 | | 60 | | 40 | |
| Kl/4 | | 65 | 35 | | |
| Kl/5 | 30 | 30 | | 40 | |

3. Probenherstellung

Streifen der Kupferfolie wurden mit Methylethylketon abgewischt und auf eine Glasplatte gegeben. Dann wurde eine 50 Gew.-%ige Lösung des Klebstoffes in Methylethylketon über die Streifen gegossen, ca. 15 min trocknen gelassen und anschliessend in einem Umluftofen 10 min auf 100°C erwärmt.

Inzwischen wurde eine Heizplatte auf ca. 120°C aufgeheizt und mit Aluminiumfolie abgedeckt. Dann wurden die erhitzten Streifen auf die Heizplatte gelegt. Die Polyimidfolie wurde mittels einer Walze mit der konvexen Seite gegen die Kupferfolie auf die Streifen aufgezogen. Schliesslich wurde die Verklebung in einer Presse bei 200°C während 1 h gehärtet.

4. Bestimmung der Schälhaftung

Bei allen Verklebungen ist die Schälfestigkeit höher als die Reissfestigkeit der Polyimidfolie.

Für Versuche auf der Zwick-Zugprüfmaschine wurden Proben mit nicht verklebtem Anfangsbereich hergestellt. Die Streifenbreite betrug 6 mm, die Abzugsgeschwindigkeit 100 mm/min; Zugrichtung 180°.

Es wurden Werte bis 1,7 N/mm gemessen, wobei in allen Fällen die Polyimidfolie riss bevor es zur Abschälung kam.

5. Reissfestigkeit

Zur Prüfung, ob die Reissfestigkeit der Polyimidfolie durch die Verklebung vermindert wird, wurden mit dem Kleber Kl/1 folgende Proben hergestellt:

| Probe Nr. | Kupfer-folie | Polyimid-folie | Kleb-stoff | Reissfestigkeit N/mm | Bemerkungen |
|---|---|---|---|---|---|
| 1 | Cu/1 | PI/2 | Kl/1 | 3,8/3,8 | 1) |
| 2 | Cu/2 | PI/2 | Kl/1 | 3,8/3,9 | 1) |
| 3 | Cu/1 | PI/1 | Kl/1 | 4,5/3,5 | 1) |
| 4 | Cu/2 | PI/1 | Kl/1 | 3,9/4,3 | 1) |
| 5 | 2) | PI/1 | | 5,5 | 3) |
| 6 | 2) | PI/2 | | 5,7 | 3) |
| 7 | Cu/2 | PI/1 | | >12,3 | 3) |
| 8 | Cu/2 | 2) | | 11,8 | 3) |

Bemerkungen:

1) mit Ultra Etch 9151 abgeätzt

2) nicht verklebt

3) nicht abgeätzt

Die Restfestigkeit der abgeätzten Polyimidfolie wird demnach durch die Verklebung nicht wesentlich herabgesetzt. Sie liegen wesentlich über den Reissfestigkeiten bei den Schälversuchen.

6. Thermische Beständigkeit

Die Probe 4, 4 h/220°C nachgehärtet, nicht abgeätzt, zeigt bei der DSC-Messung ("Differential Scanning Calorimetry") eine Glasübergangstemperatur von 264°C.

**Patentansprüche**

**1.** Verfahren zum Verkleben von Polyimidfolien, dadurch gekennzeichnet, dass man als Klebstoff thermisch härtbare Oxazenharze, welche mindestens eine 1-Oxa-3-aza-tetralin-Gruppe im Molekül enthalten, allein oder in Kombination mit einem härtbaren Epoxyharz einsetzt.

**2.** Verfahren nach Anspruch 1, dadurch gekennzeichnet, dass das Oxazenharz mehr als eine 1-Oxa-3-aza-tetralin-Gruppe im Molekül aufweist.

**3.** Verfahren nach Anspruch 1 oder 2, dadurch gekennzeichnet, dass die 1-Oxa-3-aza-tetralin-Gruppe bzw. -Gruppen des Oxazenharzes am Stickstoffatom aromatisch substituiert ist bzw. sind.

**4.** Verfahren nach einem oder mehreren der Ansprüche 1 bis 3, dadurch gekennzeichnet, dass man Polypyromellitimid-Folien verklebt.

**5.** Verfahren nach einem oder mehreren der Ansprüche 1 bis 4, dadurch gekennzeichnet, dass die Epoxyverbindung cycloaliphatisch ist.

**6.** Verfahren nach Anspruch 5, dadurch gekennzeichnet, dass die Epoxyverbindung mindestens zwei Epoxygruppen im Molekül enthält, wovon mindestens eine in einem cycloaliphatischen Ring anelliert ist und die übrigen ebenfalls in einem solchen Ring anelliert oder direkt mit einem solchen Ring verknüpft sind,

wobei das Molverhältnis von Epoxygruppen zu 1-Oxa-3-aza-tetralin-Gruppen 0,2 bis 2 beträgt.

7. Verfahren nach Anspruch 6, dadurch gekennzeichnet, dass das Molverhältnis von Epoxygruppen zu 1-Oxa-3-aza-tetralin-Gruppen 0,8 bis 1,5 beträgt.

8. Verfahren nach einem oder mehreren der Ansprüche 1 bis 7, dadurch gekennzeichnet, dass das Äqivalentgewicht der Epoxyverbindung 70 bis 250 beträgt.

9. Verfahren nach Anspruch 8, dadurch gekennzeichnet, dass das Äqivalentgewicht der Epoxyverbindung 120 bis 200 beträgt.

10. Verfahren nach einem oder mehreren der Ansprüche 1 bis 9, dadurch gekennzeichnet, dass die Epoxyverbindung
    - 2-(3,4-Epoxy)cyclohexyl-5,5-spiro(3,4-epoxy)-cyclohexan-m-dioxan;
    - 1- bis 4fach methyliertes 2-(3,4-Epoxy)cyclohexyl-5,5-spiro-(3,4-epoxy)-cyclohexan-m-dioxan;
    - 4-(1,2-Epoxyethyl)-1,2-epoxycyclohexan;
    - 1,2:8,9-Diepoxy-p-menthan;
    - 2,2-Bis(3,4-epoxycyclohexyl)propan;
    - Bis(2,3-epoxycyclopentyl)ether;
    - 1,2:5,6-Diepoxy-4,7-hexahydromethanoindan;
    - Bis(3,4-epoxycyclohexylmethyl)adipat;
    - Bis(3,4-epoxy-6-methyl-cyclohexylmethyl)adipat;
    - Bis(3,4-epoxycyclohexylmethyl)-terephthalat;
    - Bis(3,4-epoxy-6-methyl-cyclohexylmethyl)-terephthalat;
    - 3,4-Epoxy-cyclohexancarbonsäure-(3,4-epoxycyclohexylmethyl)-ester;
    - 3,4-Epoxy-6-methyl-cyclohexancarbonsäure-(3,4-epoxy-6-methyl-cyclohexylmethyl)ester;
    - 1,2-Bis(5(1,2-epoxy)-4,7-hexahydromethanoindanoxy)-ethan;
    - 1,1,1-Tris((5-(1,2-epoxy)-4,7-hexahydromethanoindanoxy)methyl)-propan; oder
    - 4,5-Epoxy-hexahydrophthalsäure-bis-(3,4-epoxycyclohexylmethyl)-ester ist.

11. Verfahren nach einem oder mehreren der Ansprüche 1 bis 9, dadurch gekennzeichnet, dass die Epoxyverbindung die Formel

X—Y

aufweist, worin bedeuten:

X einen 3,4-Epoxycyclohexyl-Rest oder einen 1- oder 2fach methylierten 3,4-Epoxycyclohexyl-Rest;

Y einen Rest der Formel

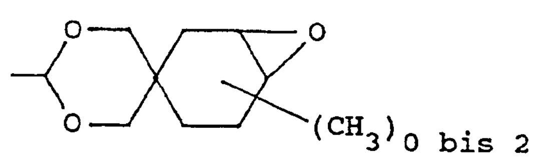

oder einen Epoxyethyl-Rest der Formel

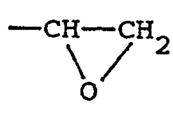

oder einen Rest der Formel

$$-COO-CH_2-X \text{ oder } -CH_2-Z-CH_2-X,$$

worin Z den Säurerest einer aliphatischen, cycloaliphatischen oder aromatischen Dicarbonsäure bedeutet.

12. Verfahren nach einem oder mehreren der Ansprüche 1 bis 11, dadurch gekennzeichnet, dass man die Polyimidfolien mit gleichartigen Folien verklebt.

**13.** Verfahren nach einem oder mehreren der Ansprüche 1 bis 11, dadurch gekennzeichnet, dass man die Polyimidfolien mit anderen Substraten verklebt.

**14.** Verfahren nach Anspruch 13, dadurch gekennzeichnet, dass man die Polyimidfolien mit Metallen verklebt.

**15.** Verfahren nach Anspruch 14, dadurch gekennzeichnet, dass man die Polyimidfolien mit Metallblechen verklebt.

**16.** Verfahren nach Anspruch 14, dadurch gekennzeichnet, dass man die Polyimidfolien mit Metallfolien verklebt.

**17.** Verfahren nach Anspruch 16, dadurch gekennzeichnet, dass man die Polyimidfolien mit Kupferfolien verklebt.

**18.** Verfahren nach Anspruch 16, dadurch gekennzeichnet, dass man die Polyimidfolien mit Aluminiumfolien verklebt.

**19.** Verfahren nach Anspruch 16, dadurch gekennzeichnet, dass man die Polyimidfolien mit Nickelfolien verklebt.

**20.** Verfahren nach Anspruch 16, dadurch gekennzeichnet, dass man die Polyimidfolien mit Widerstandsfolien verklebt.

**21.** Leiterplatte bestehend aus einer Polyimid-Trägerfolie und einer Metallfolie, hergestellt nach dem Verfahren gemäss Anspruch 16.

Europäisches Patentamt

# EUROPÄISCHER RECHERCHENBERICHT

Nummer der Anmeldung

EP 91 81 0320

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 178 414 (GURIT-ESSEX AG)<br>* Ansprüche 1-18 *<br>--- | 1-21 | C 09 J 161/20<br>C 09 J 163/00 |
| D,A | EP-A-0 356 379 (GURIT-ESSEX AG)<br>* Ansprüche 1-20 *<br>----- | 1-21 | |
| | | | RECHERCHIERTE SACHGEBIETE (Int. Cl.5) |
| | | | C 09 J<br>C 08 L<br>C 08 J |

Der vorliegende Recherchenbericht wurde für alle Patentansprüche erstellt

| Recherchenort | Abschlußdatum der Recherche | Prüfer |
|---|---|---|
| DEN HAAG | 02-09-1991 | GLANDDIER A. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)